# EUROPEAN PATENT APPLICATION

(11) **EP 4 113 593 A2**
(43) Date of publication of application: **04.01.2023**
(21) Application number: 22182395.8
(22) Date of filing: 30.06.2022
(51) Int. Cl.: H01L 23/36, H01L 23/32

(54) **POLYIMIDE BONDED BUS BAR FOR POWER DEVICE**

(30) Priority: 01.07.2021 US 202117365048
(71) Applicant: Hamilton Sundstrand Corporation, Charlotte, NC 28217-4578 (US)
(72) Inventor: FENG, Frank Z., Loves Park, 61111-8918 (US)
(74) Representative: Dehns

(57) **Abstract**

Disclosed is a semiconductor article including: a metal bus bar (15) and a metal heat sink (40) wherein at least a portion of a first side of the metal bus bar is bonded to at least a portion of the metal heat sink by a polyimide layer without adhesive; and a semiconductor power device (10) disposed on a second side of the metal bus bar.

## Description

### BACKGROUND

Exemplary embodiments pertain to the art of bus bars for semiconductor devices.

Heat and power flow separation in semiconductor devices is frequently achieved through the use of thermal pads. These pads are installed between bus bar and heat sink. Typically more than one pad is used in order to prevent pin hole line up. The thermal pads are a limiting factor for device integrity and performance due to electrical, mechanical and thermal limits. Better solutions for heat and power flow separation are needed.

### BRIEF DESCRIPTION

Disclosed is a semiconductor article including: a metal bus bar and a metal heat sink wherein at least a portion of a first side of the metal bus bar is bonded to at least a portion of the metal heat sink by a polyimide layer without adhesive; and a semiconductor power device disposed on a second side of the metal bus bar.

In embodiments, the first side of the metal bus bar is opposite the second side of the metal bus bar.

In embodiments, the semiconductor article has a power flow direction and a heat flow direction and the power flow direction is different from the heat flow direction.

In embodiments, the metal bus bar consists of a metal, a metal alloy, or a combination of metals.

In embodiments, only the first side of the metal bus bar is bonded to the polyimide layer.

In embodiments, the bond between the metal bus bar and polyimide layer is free of voids.

In embodiments, the bond between the metal heat sink and polyimide layer is free of voids.

In embodiments, the metal bus bar and the polyimide layer each have a coefficient of thermal expansion (CTE) and the polyimide layer CTE is 90-110% of the metal bus bar CTE.

In embodiments, the metal heat sink and the polyimide layer each have a coefficient of thermal expansion (CTE) and the polyimide layer CTE is 90-110% of the metal heat sink CTE.

In embodiments, the semiconductor article may further include an additional semiconductor device disposed on a side of the metal bus bar other than the first side.

In embodiments, the metal bus bar comprises aluminum or an aluminum alloy.

In embodiments, the semiconductor article further includes an additional metal bus bar having at least a portion of a first side of the additional metal bus bar bonded to at least a portion of the metal heat sink by the polyimide layer or an additional polyimide layer and an additional semiconductor power device disposed on a second side of the additional metal bus bar.

Also disclosed is a method of making a semiconductor article. The method includes including bonding a metal bus bar to a metal heat sink by locating a polyimide layer between at least a portion of a first side of the metal bus bar and at least a portion of the metal heat sink to form a stack without adhesive and heating the stack to bond the stack; and disposing a semiconductor power device on a second side of the metal bus bar.

In embodiments, the stack is heated to a temperature of 380°C to 420°C.

In embodiments, the metal bus bar comprises aluminum or an aluminum alloy.

In embodiments, the stack is heated to a temperature above the glass transition temperature of the polyimide and below the degradation temperature of the polyimide.

### BRIEF DESCRIPTION OF THE DRAWINGS

The following descriptions should not be considered limiting in any way. With reference to the accompanying drawings, like elements are numbered alike:
FIG. 1 shows a semiconductor article with a single semiconductor device;
FIG. 2 shows an embodiment of a semiconductor article with two bus bars and two semiconductor devices; and
FIG. 3 shows another embodiment of a semiconductor article with two bus bars and two semiconductor devices.

### DETAILED DESCRIPTION

A detailed description of one or more embodiments of the disclosed apparatus and method are presented herein by way of exemplification and not limitation with reference to the Figures.

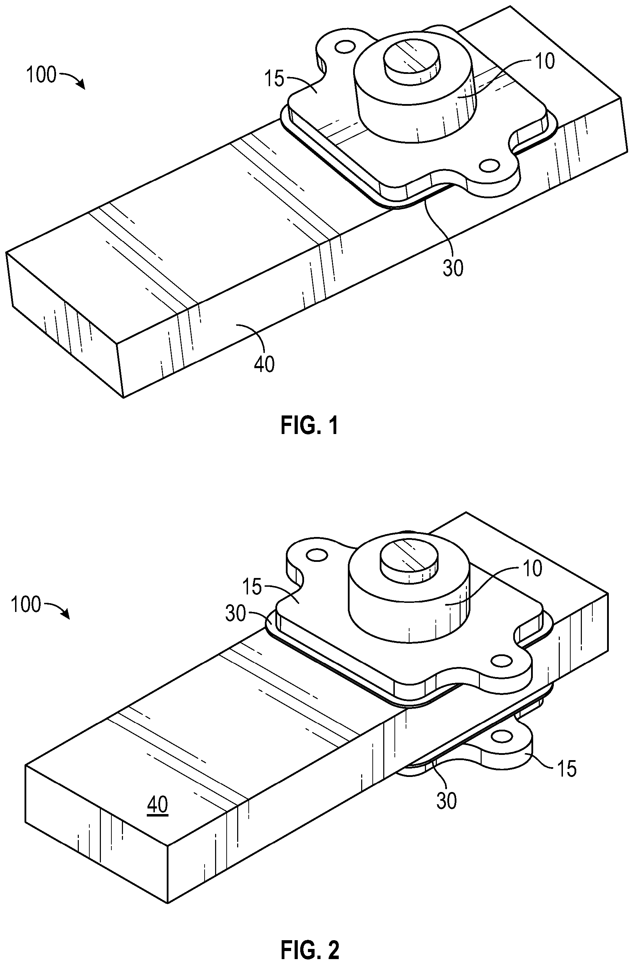

FIG. 1 shows a semiconductor article 100 having a first side of metal bus bar 15 bonded to metal heat sink 40 by polyimide layer 30. Semiconductor device 10 is located on bus bar 15. Power flows through the metal bus bar in a direction different from the direction of the heat flow in the metal heat sink.

The polyimide layer 30 is bonded to the metal bus bar 15 and metal heat sink without adhesive. The bond to the metal bus bar and to the metal heat sink is effected by using heat and optionally pressure. By bonding the polyimide to the metal bus bar and metal heat sink under these conditions air pockets (voids) are eliminated which makes the resulting bus bar more reliable, consistent and robust. The metal bus bar may be a metal, a metal alloy or a combination of metals. Exemplary metals and metal alloys include aluminum and aluminum alloys. The metal bus bar may have a similar coefficient of thermal expansion to the polyimide layer. In some embodiments, the polyimide layer coefficient of thermal expansion is 90 to 110% of the metal bus bar coefficient of thermal expansion.

The metal heat sink may be a metal, a metal alloy or a combination of metals. Exemplary metals and metal alloys include aluminum and aluminum alloys. The metal heat sink may have a similar coefficient of thermal expansion to the polyimide layer. In some embodiments, the polyimide layer coefficient of thermal expansion is 90 to 110% of the metal heat sink coefficient of thermal expansion.

The metal bus bar is bonded to the metal heat sink by locating the polyimide layer between the metal bus bar and the metal heat sink to form a stack and then subjecting the stack to a temperature that is greater than the glass transition temperature of the polyimide and less than the degradation temperature of the polyimide. Representative temperatures are 380°C to 420°C. While at that temperature, the stack may be subjected to an elevated pressure (greater than atmospheric pressure). The stack may be subjected to the elevated temperature for a time sufficient to result in bonding, more specifically for a time sufficient to allow the polyimide at the surface of the metal bus bar and the metal heat sink to flow into the surface structure of the metal bus bar and the metal heat sink, thus forming a bond without voids. After the metal bus bar and the metal heat sink have been bonded a semiconductor device such as a semiconductor power device is attached to the metal bus bar using an appropriate attachment means such as a threaded fastener.

Bonding the polyimide portion to the metal portion facilitates fabrication of the semiconductor article as there is no need to locate a separate thermal pad or multiple thermal pads between the bus bar and heat sink. Additionally, semiconductor article produced as described above has more resilience to temperature cycling and a higher operating temperature. The higher operating temperature improves the power density of the device.

Semiconductor device 10 may be a semiconductor power device or any other semiconductor device without limitation. The semiconductor device includes at least one semiconductor chip and may further include one or more circuit boards including insulating circuit boards and printed circuit boards. Examples of semiconductor chips include a switching element such as insulated gate bipolar transistor (IGBT), and a power metal oxide semiconductor field effect transistor (power MOSFET) and a diode such as a freewheeling diode (FWD). Also, elements such as a reverse conducting (RC)-IGBT, including integrated IGBT and FWD, and reverse blocking (RB)-IGBT may be used.

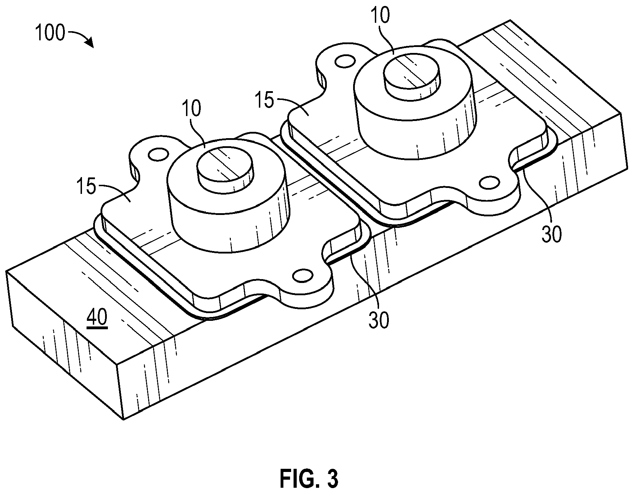

The semiconductor article is not limited to a single semiconductor device, a single bus bar and a single heat sink. FIG. 1 shows a single semiconductor device, a single bus bar and a single heat sink for simplicity. Other configurations are contemplated such as those shown in FIGS. 2 and 3 which have two semiconductor devices and two bus bars but only one heat sink. Any combination of semiconductor devices, bus bars and heat sinks may be used.

The terminology used herein is for the purpose of describing particular embodiments only and is not intended to be limiting of the present disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof. The terms "comprises" and/or "comprising" as well as "includes" and/or "including" includes "consists of and/or "consisting of."

While the present disclosure has been described with reference to an exemplary embodiment or embodiments, it will be understood by those skilled in the art that various changes may be made without departing from the scope of the invention as defined by the claims. In addition, many modifications may be made to adapt a particular situation or material to the teachings of the present disclosure without departing from the scope of the claims . Therefore, it is intended that the present disclosure not be limited to the particular embodiment disclosed as the best mode contemplated for carrying out this present disclosure, but that the present disclosure will include all embodiments falling within the scope of the claims.

## Claims

1. A semiconductor article comprising a metal bus bar (15) and a metal heat sink (40) wherein at least a portion of a first side of the metal bus bar is bonded to at least a portion of the metal heat sink by a polyimide layer without adhesive; and a semiconductor power device (10) disposed on a second side of the metal bus bar.

2. The semiconductor article of claim 1, wherein the first side of the metal bus bar (15) is opposite the second side of the metal bus bar.

3. The semiconductor article of claim 1 or 2, wherein the semiconductor article (100) has a power flow direction and a heat flow direction and the power flow direction is different from the heat flow direction.

4. The semiconductor article of any preceding claim, wherein the metal bus bar consists of a metal, a metal alloy or a combination of metals.

5. The semiconductor article of any preceding claim, wherein only the first side of the metal bus bar is bonded to the polyimide layer.

6. The semiconductor article of any preceding claim, wherein the bond between the metal bus bar and polyimide layer is free of voids.

7. The semiconductor article of any preceding claim, wherein the bond between the metal heat sink and polyimide layer is free of voids.

8. The semiconductor article of any preceding claim , wherein the metal bus bar and the polyimide layer each have a coefficient of thermal expansion, CTE, and the polyimide layer CTE is 90-110% of the metal bus bar CTE.

9. The semiconductor article of any of claims 1 to 7 wherein the metal heat sink and the polyimide layer each have a coefficient of thermal expansion, CTE, and the polyimide layer CTE is 90-110% of the metal heat sink CTE.

10. The semiconductor article of any preceding claim , further comprising at least a portion of a first side of an additional metal bus bar bonded to at least a portion of the metal heat sink by an additional polyimide layer without adhesive; and an additional semiconductor power device disposed on a second side of the additional metal bus bar.

11. The semiconductor article of any preceding claim , wherein the metal bus bar comprises aluminum or an aluminum alloy.

12. A method of making a semiconductor article comprising:
bonding a metal bus bar (15) to a metal heat sink (40) by locating a polyimide layer between at least a portion of a first side of the metal bus bar and at least a portion of the metal heat sink to form a stack without adhesive and heating the stack to bond the stack; and
disposing a semiconductor power device (10) on a second side of the metal bus bar.

13. The method of claim 12, wherein the stack is heated to a temperature of 380°C to 420°C.

14. The method of claim 12 or 13, wherein the metal bus bar comprises aluminum or an aluminum alloy.

15. The method of claim 12, 13 or 14, wherein the stack is heated to a temperature above the glass transition temperature of the polyimide and below the degradation temperature of the polyimide.
